# EUROPÄISCHE PATENTANMELDUNG

(11) **EP 0 864 670 A2**
(43) Veröffentlichungstag der Anmeldung: **16.09.1998**
(21) Anmeldenummer: 98101456.6
(22) Anmeldetag: 28.01.1998
(51) Int. Cl.: C30B 15/00

(54) **Hebezeug für eine Vorrichtung zum Ziehen von Einkristallen**

(30) Priorität: 15.03.1997 DE 19710856
(71) Anmelder: Leybold Systems GmbH, D-63450 Hanau am Main (DE)
(72) Erfinder: Schulmann, Winfried, 63801 Kleinostheim (DE)

(57) **Zusammenfassung**

Bei einem Hebezeug für eine Vorrichtung zum Ziehen von Einkristallen (2) ist ein die Ziehwelle (3) und/oder den Kristall (2) umschließender, sich in einer horizontalen Ebene erstreckender Rahmen (4) mit mindestens zwei Lagern (20,21), mit in diesen gehaltenen, in vertikalen Ebenen schwenkbaren zweiarmigen Greifern (7,8) vorgesehen, wobei jeweils ein Greiferarm (7',8') auf die Rotationsachse (R) des Rahmens (4) ausgerichtet und dabei in seiner Länge (f,f') so bemessen ist, daß in einer Schließposition die einander zugekehrten Stirnflächen (9,10) der Greiferarme (7',8') fest aneinanderliegend nur eine begrenzte Schwenkbewegung ermöglichen, wobei jeweils die freien Enden (7'',8'') der zweiarmigen Greifer (7,8) an sich etwa vertikal erstreckenden Zugstangen (11,12) angelenkt sind, deren jeweils obere Enden über einen sich horizontal erstreckenden Jochbalken (13) gelenkig miteinander verbunden sind, wobei der Jochbalken (13) mit Spindelmutter (17) über eine Gewindespindel (14) entlang der Ziehwelle (3) verstellbar ist, und wobei der Rahmen (4) an Seilzügen (15,16) hängt, über die die Greiferarme (7,8) verschwenkbar sind.

## Beschreibung

Die Erfindung betrifft ein Hebezeug für eine Vorrichtung zum Ziehen von Einkristallen aus einer in einem Tiegel befindlichen Schmelze unter Vakuum oder unter Schutzgas bei vermindertem Druck, wobei der Tiegel in einer auf einem Grundgestell abgestützten Vakuumkammer angeordnet und durch die Wärmestrahlung eines Heizelementes erhitzbar ist, und wobei eine Ziehwelle oberhalb der Schmelze vorgesehen ist, mit der der Kristall von der Schmelzenoberfläche aus nach oben zu in eine gegenüber dem Grundgestell verfahrbare Schleusenkammer herausziehbar ist, wobei das Hebezeug vom Gehäuse der Schleusenkammer, von einem auf dem Grundgestell abgestützten Obergestell oder der Ziehwelle gehalten ist.

Üblicherweise wird der in der Schleusenkammer am Impfling hängende Kristall von einem besonderen Handlingsystems durch die an der Schleusenkammer vorgesehene seitliche Öffnung gegriffen, dann vom Impfling abgetrennt und schließlich mit Hilfe des Handlingsystems aus der von einer Klappe verschließbaren Öffnung seitlich aus der Schleusenkammer herausgefahren.

Dies bekannte Verfahren hat eine Reihe von Nachteilen, die alle aus der besonderen Empfindlichkeit des Kristalls gegenüber Stößen und Erschütterungen resultieren. Darüber hinaus besteht die Gefahr, daß der Kristall nicht richtig vom Handlingsystem erfaßt wird, weil er in der Schleusenkammer hängend nicht frei zugänglich ist.

Es sind auch Vorrichtungen bekannt, bei denen nach dem Ziehprozeß und nach dem Belüften der Schleusenkammer diese zusammen mit der sperrigen und schweren Ziehwelle und mit dem Wellenantrieb am Gestell der Vorrichtung verschwenkt wird, so daß der Kristall auf einem unter die Schleusenkammer gefahrenen Transportwagen abgesenkt werden bzw. von diesem übernommen werden kann. Derartige Vorrichtungen haben jedoch den ganz entscheidenden Nachteil, daß bei der Größe einer Ziehvorrichtung und dem Gewicht ihrer Einzelteile die für den Ziehprozeß erforderliche Stellung der einzelnen Teile zueinander im Dauerbetrieb nicht gewährleistet werden kann, insbesondere ist es erfahrungsgemäß kaum möglich die empfindliche und hochpräzise Ziehwelle mitsamt ihrem Antrieb immer wieder winkelgenau in ihre Arbeitsposition oberhalb der Schmelze zu manövrieren.

Der vorliegenden Erfindung liegt die Aufgabe zugrunde, eine Vorrichtung des eingangs genannten Typs so auszubilden, daß der Kristall sicher und stoßfrei in der Schleusenkammer aufwachsen kann und der fertige Kristall sich entnehmbar und transportierbar ist, und zwar ohne daß empfindliche Teile der Vorrichtung aus ihrer Arbeitsposition entfernt werden oder Umbauten an der Schleusenkammer vorgenommen werden müssen.

Gemäß der vorliegenden Erfindung wird diese Aufgabe gelöst durch einen die Ziehwelle und/oder den Kristall umschließenden, sich in einer horizontalen Ebene erstreckenden Rahmen mit mindestens zwei Lagern, mit in diesen gehaltenen, in vertikalen Ebenen schwenkbaren zweiarmigen Greifern, deren jeweils einer Greiferarm auf die Rotationsachse des Rahmens ausgerichtet und dabei in seiner Länge so bemessen ist, daß in einer Schließposition die einander zugekehrten Stirnflächen der Greiferarme fest aneinanderliegend eine weitere Schwenkbewegung verhindern, wobei jeweils die freien Enden der zweiarmigen Greifer an sich etwa vertikal erstreckenden Zugstangen angelenkt sind, deren jeweils obere Enden über einen sich horizontal erstreckenden Jochbalken gelenkig miteinander verbunden sind, wobei der Jochbalken mit Spindelmutter über eine Gewindespindel entlang der Ziehwelle verstellbar ist, und wobei der Rahmen an Seilzügen hängt, die an einer Halteeinrichtung arretierbar oder auf einem Rollenzug aufwickelbar sind, die bzw. der auf dem Deckel der Schleusenkammer oder am Grundgestell oberhalb der Schleusenkammer gehalten ist.

Weitere Einzelheiten und Merkmale der Erfindung sind in den Unteransprüchen näher gekennzeichnet und beschrieben.

Die Erfindung läßt die verschiedensten Ausführungsmöglichkeiten zu; eine davon ist in den anhängenden Zeichnungen rein schematisch näher dargestellt, und zwar zeigen:
- Fig. 1: das Hebezeug in perspektivischer Darstellung, wobei sich die beiden Greiferarme in der Offen-Position befinden,
- Fig. 2: das Hebezeug gemäß Fig. 1, jedoch mit den Greiferarmen in der Schließ-Position und
- Fig. 3: eine Vorrichtung zum Ziehen von Einkristallen in perspektivischer Ansicht und stark vereinfacht dargestellt.

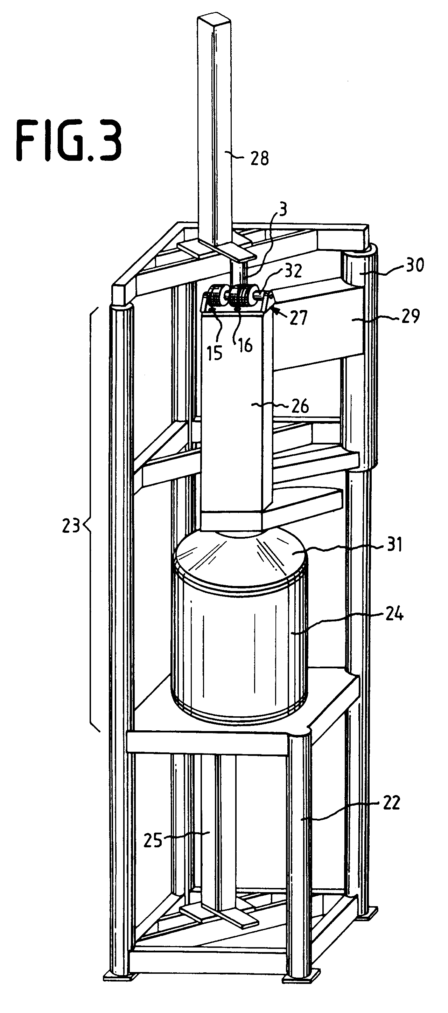

Wie Figur 3 zeigt, besteht die Ziehvorrichtung aus einem vierbeinigen Grundgestell 22, auf das ein dreibeiniges Grundgestell 23 aufgesetzt ist, einer auf dem Grundgestell ruhenden Vakuumkammer 24 mit Deckel 31 und mit dem in der Kammer befindlichen Tiegel mit Heizung, einem von unten her in die Vakuumkammer 24 hineinragenden Tiegeltragbolzen 25, einer Schleusenkammer 26 mit Kammerdeckel 27, einer von oben her in die Schleusenkammer 26 eintauchenden Ziehwelle 3 mit Antriebsspindel 28 sowie dem Schwenkarm 29 mit Schwenklager 30 zum Verfahren der Schleusenkammer 26.

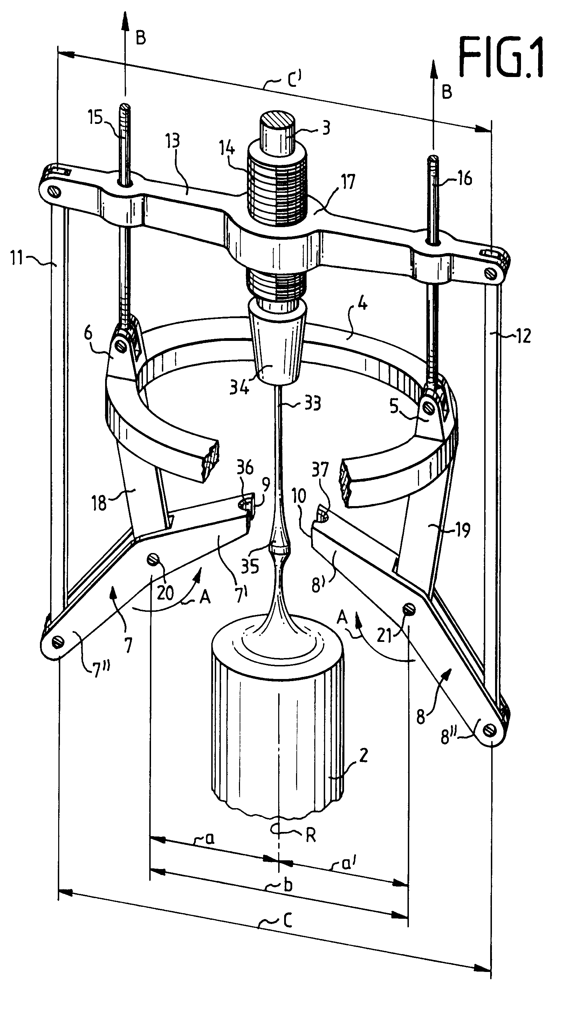

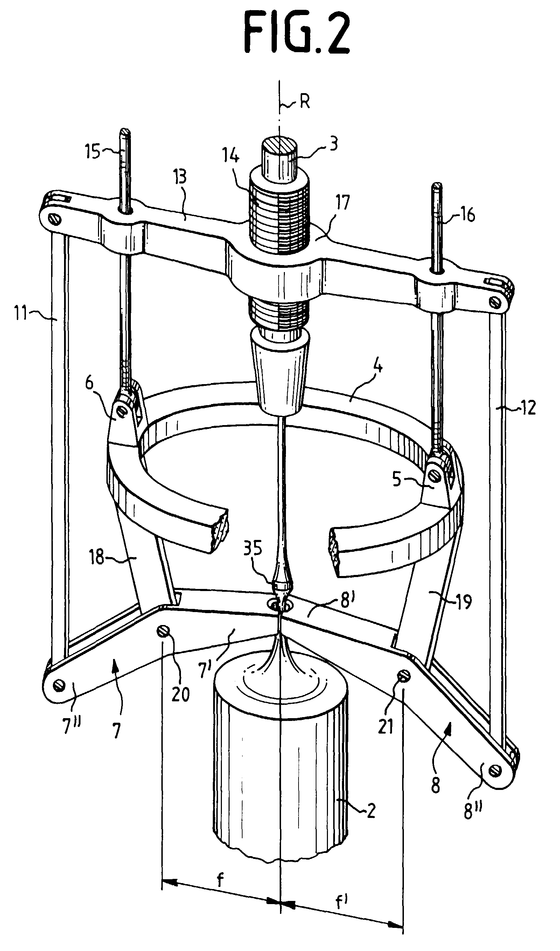

Der fertige, aus der Schmelze in die Schleusenkammer 26 gezogene Einkristall 2 hängt mit seinem hohen Gewicht an dem sehr dünnen Keimkristall 33, wobei die Gefahr besteht, daß der Keimkristall bereits bei geringen Erschütterungen bricht, so daß der fertige Kristall 2 nach unten zu in die Vakuumkammer 24 fällt, was diesen naturgemäß zerstört und auch die Anlage für längere Zeit unbrauchbar werden läßt. Um ein solches Abstürzen des fertigen Kristalls 2 zu verhindern, befindet sich in der Schleusenkammer 26 die in den Figuren 1 und 2 dargestellte Vorrichtung zum Halten, Heben und Führen des Kristalls 2, bestehend im wesentlichen aus dem den Keimkristall 33 oder die Ziehwelle 3 umschließenden Rahmen 4 mit den Lagern 5,6 für die Seilzüge 15,16, die durch Öffnungen im Kammerdeckel 27 hindurchgeführt und vom Rollenzug 32 mit Motor aufwickelbar sind, der die Ziehwelle 3 umschließenden Spindel 14 mit Jochbalken 13 mit Spindelmutter 17, den beiden an den Enden des Jochbalkens 13 angelenkten Zugstangen 11,12 gleicher Länge und den fest mit dem Rahmen 4 verbundenen Nasen 18,19 mit Lagern 20,21 für die zweiarmigen Greifer 7,8, deren voneinander abgekehrte Enden 7'',8'' an die Zugstangen 11,12 angelenkt sind.

Zwischen dem Spannfutter 34 der Ziehwelle 3 für den Keimkristall 33 und dem Kristall 2 selbst befindet sich eine Verdickung 35, die von den beiden Greifern 7,8 bzw. ihren Greiferarmen 7',8' in der Schließ-Position umgriffen wird, wozu sich die Stirnflächen 9,10 der Greiferarme 7',8' gegeneinander legen und so verhindern, daß die Greifer 7,8 entgegen der Pfeilrichtung A nach unten zu weiterschwenken. Die Stirnflächen 9,10 der beiden Greiferarme 7',8' sind mit Ausnehmungen 36,37 versehen, die so ausgeformt sind, daß sie beide zusammen einen kegeligen oder trichterförmigen Durchlaß bilden, der die Verdickung 35 umschließt, fängt und hält, so daß das hohe Gewicht des in die Schleusenkammer 26 gezogenen Kristalls 2 über die Ausnehmungen 36,37 auf die Greiferarme 7,8 und von diesen über die Zugstangen 11,12 und den Jochbalken 13 auf die Ziehmutter bzw. (die mit einem selbsthemmenden Gewinde versehene) Spindel 14 der Ziehwelle 3 übertragen wird. Die Ziehwelle 3 trägt die Last, da der Jochbalken 13 über die Spindel 14 mit ihr gekoppelt ist, wobei sichergestellt ist, daß bei einem Bruch des Keimkristalls 33 oberhalb der Verdickung 35 oder wenn dieser an dieser Stelle durchtrennt wird, um den fertigen Kristall 2 der Schleusenkammer 26 entnehmen zu können, ein Absturz des Kristalls 2 nach unten in die Vakuumkammer 24 sicher verhindert wird.

Die Länge f,f' der Arme 7',8' der Greifer 7,8 ist so bemessen, daß der Abstand der jeweiligen Stirnfläche 9 bzw. 10 von der Drehachse 20 bzw. 21 größer ist als der Abstand a bzw. a'. Das Maß c entspricht in der Schließstellung (Fig. 2) etwa dem Maß c'. Zum Öffnen der Greiferarme 7,8 werden die Seilzüge 15,16 mit Hilfe des Rollenzugs 32 in Pfeilrichtung B nach oben gezogen, wobei die Greiferarme 7,8 in Pfeilrichtung A um die in Abstand b angeordneten Lagerbolzen 20,21 verschwenkt werden. Eine Verstellung des gesamten Hebezugs in vertikaler Richtung gegenüber dem Kristall 2 erfolgt durch Drehen der Spindel 14 gegenüber dem Jochbalken 13.

Wenn die Greiferarme 7,8 sich in der in Fig. 2 dargestellten Schließ-Position befinden und der Kristall mit seiner Verdickung 35 in den Ausnehmungen 36,37 ruht, können die Seilzüge 15,16 vollständig entlastet werden und kraftlos durchhängen.

### Bezugszeichenliste

- 2: Kristall
- 3: Ziehwelle
- 4: Rahmen
- 5: Lager
- 6: Lager
- 7: zweiarmiger Greifer
- 8: zweiarmiger Greifer
- 9: Stirnfläche
- 10: Stirnfläche
- 11: Zugstange
- 12: Zugstange
- 13: Jochbalken
- 14: Spindel
- 15: Seilzug
- 16: Seilzug
- 17: Spindelmutter
- 18: Nase
- 19: Nase
- 20: Lager, Lagerbolzen
- 21: Lager, Lagerbolzen
- 22: Grundgestell
- 23: Obergestell
- 24: Vakuumkammer
- 25: Tiegeltragbolzen
- 26: Schleusenkammer
- 27: Kammerdeckel
- 28: Antriebsspindel
- 29: Schwenkarm
- 30: Schwenklager
- 31: Vakuumkammerdeckel
- 32: Rollenzug mit Motor
- 33: Keimkristall
- 34: Spannfutter
- 35: Verdickung
- 36: Ausnehmung
- 37: Ausnehmung

## Patentansprüche

1. Hebezeug für eine Vorrichtung zum Ziehen von Einkristallen (2) aus einer in einem Tiegel befindlichen Schmelze unter Vakuum oder unter Schutzgas bei vermindertem Druck, wobei der Tiegel in einer auf einem Grundgestell (22) abgestützten Vakuumkammer (24) angeordnet und durch die Wärmestrahlung eines Heizelementes erhitzbar ist, und wobei eine Ziehwelle (3) oberhalb der Schmelze vorgesehen ist, mit der der Kristall (2) von der Schmelzenoberfläche aus nach oben zu in eine gegenüber dem Grundgestell (22) verfahrbare Schleusenkammer (26) herausziehbar ist, wobei das Hebezeug vom Gehäuse der Schleusenkammer (26), von einem auf dem Grundgestell (24) abgestützten Obergestell (23) oder der Ziehwelle (3) gehalten ist, mit einem die Ziehwelle (3) und/oder den Kristall (2) umschließenden, sich in einer horizontalen Ebene erstreckenden Rahmen (4) mit mindestens zwei Lagern (20,21), mit in diesen gehaltenen, in vertikalen Ebenen schwenkbaren zweiarmigen Greifern (7,8), wobei jeweils ein Greiferarm (7',8') auf die Rotationsachse (R) des Rahmens (4) ausgerichtet und dabei in seiner Länge (f,f') so bemessen ist, daß in einer Schließposition die einander zugekehrten Stirnflächen (9,10) der Greiferarme (7',8') fest aneinanderliegend eine weitere Schwenkbewegung (A) verhindern, wobei jeweils die freien Enden (7'',8'') der zweiarmigen Greifer (7,8) an sich etwa vertikal erstreckenden Zugstangen (11,12) angelenkt sind, deren jeweils obere Enden über einen sich horizontal erstreckenden Jochbalken (13) gelenkig miteinander verbunden sind, wobei der Jochbalken (13) mit Spindelmutter (17) über eine Gewindespindel (14) entlang der Ziehwelle (3) verstellbar ist, und wobei der Rahmen (4) an Seilzügen (15,16) hängt, die auf einem Rollenzug (32) aufwickelbar sind, der auf dem Deckel (27) der Schleusenkammer (26) oder am Grundgestell (22 bzw. 23) oberhalb der Schleusenkammer (26) gehalten ist.

2. Hebezeug nach Anspruch 1, **dadurch gekennzeichnet**, daß die auf die Rotationsachse (R) ausgerichteten Arme 7',8' der am Rahmen (4) angelenkten Greifer (7,8) jeweils eine Länge (f,f') aufweisen, die geringfügig größer bemessen ist als der halbe Abstand (b), den die beiden Lagerbolzen (20,21) voneinander aufweisen.

3. Hebezeug nach den Ansprüchen 1 und 2, **dadurch gekennzeichnet**, daß die einander zugekehrten Stirnflächen (9,10) mit sich vertikal erstreckenden Ausnehmungen (36,37) versehen sind, die keilartig oder kalottenförmig ausgebildet sind.

4. Hebezeug nach den Ansprüchen 1 bis 3, **dadurch gekennzeichnet**, daß der sich horizontal erstreckende Jochbalken (13) mit seiner Spindelmutter (17) mit der auf die Ziehwelle (3) aufgeschobenen Spindel (14) verschraubt ist und die Spindel (14) gegenüber der Ziehwelle (3) verdrehbar und drehfest mit dieser verbindbar ist.
